# EUROPEAN PATENT APPLICATION

(11) **EP 4 513 577 A1**
(43) Date of publication of application: **26.02.2025**
(21) Application number: 22938298.1
(22) Date of filing: 29.11.2022
(51) Int. Cl.: H01L 31/18, H01L 31/068

(54) **PREPARATION METHOD FOR SOLAR CELL AND SOLAR CELL**

(30) Priority: 20.04.2022 CN 202210415006
(71) Applicant: Tongwei Solar (Chengdu) Co., Ltd., Chengdu, Sichuan 610299 (CN)
(72) Inventor: FAN, Jianbin, Meishan, Sichuan 620041 (CN); MENG, Xiajie, Meishan, Sichuan 620041 (CN); XING, Guoqiang, Meishan, Sichuan 620041 (CN)
(74) Representative: Michalski Hüttermann & Partner Patentanwälte mbB
(86) International application number: PCT/CN2022/134855
(87) International publication number: WO 2023/202079

(57) **Abstract**

The present application provides a preparation method for a solar cell and a solar cell. The preparation method for the solar cell includes: providing a silicon wafer having a first surface and a second surface opposite to the first surface; forming an ultrathin silicon oxide layer on the first surface of the silicon wafer, and sequentially forming a phosphorus-doped amorphous silicon layer and a silicon oxide mask layer on the ultrathin silicon oxide layer; and annealing the silicon wafer to densify the silicon oxide mask layer. **In** the present application, the phosphorus-doped amorphous silicon layer and the silicon oxide mask layer are sequentially formed on the ultrathin silicon oxide layer and then annealed, so that the thickness of the silicon oxide mask layer can be conveniently controlled, and the silicon oxide mask layer can be densified to further enhance the corrosion resistance of the silicon oxide mask layer in an alkaline solution. **In** the method of the present application, the polycrystalline silicon layer in the N-type region can be well protected from corrosion, and a texturing time window in a subsequent texturing process can be expanded.

## Description

### CROSS-REFERENCE TO RELATED APPLICATIONS

This application claims priority to Chinese Patent Application No. 202210415006X, entitled "P-TYPE BACK CONTACT SOLAR CELL AND PREPARATION METHOD THEREOF" and filed to the China Patent Office on April 20, 2022, the content of which is hereby incorporated by reference in its entirety.

### TECHNICAL FIELD

The present application relates to the technical field of solar cell manufacture, and in particular to a preparation method for a solar cell and a solar cell.

### BACKGROUND

In back contact cells, an interdigitated back contact (IBC) solar cell is also referred to as an IBC cell. The IBC cell is characterized in that both a PN junction region or a PN-like junction region and a metal electrode are located on a back surface of the cell and a front surface of the cell is not covered by the metal electrode.

Due to the above structural characteristics, the IBC cell has a high short-circuit current *Jsc,* as well as an increased fill factor (FF) due to reduced series resistance *Rs* as a wider metal grid line is allowed to formed on the back surface. Moreover, such a cell with the front surface not covered exhibits both high conversion efficiency and aesthetic appeal. Therefore, the IBC cell has become one of the current technical directions for realizing high-efficiency crystalline silicon cells.

Conventionally, in preparation of a P-type back contact solar cell, an amorphous silicon layer is generally firstly formed by low-pressure chemical vapor deposition (LPCVD), and then phosphorus diffusion is performed on the amorphous silicon layer to form phosphorus-doped polycrystalline silicon layer and silicon oxide mask layer on the P-type silicon wafer. The silicon oxide mask layer prepared in this manufacturing process is a phosphorosilicate glass (PSG) formed by the amorphous silicon layer through the phosphorus diffusion. Such a phosphorus-doped silicon oxide mask layer can protect the polycrystalline silicon layer on a back surface of the P-type silicon wafer to some extent during texturing, preventing the polycrystalline silicon layer from being damaged by the alkali-containing texturing liquid to some extent.

However, since the silicon oxide mask layer prepared by the above process is formed by phosphorus diffusion on the amorphous silicon layer, the growth of the silicon oxide mask layer is a self-limiting reaction, and the prepared silicon oxide mask layer generally has a very small thickness (less than 20 nm), resulting in a short resistance time to the alkali corrosion. Moreover, the high phosphorus doping concentration in the silicon oxide mask layer may also reduce the alkali resistance of the silicon oxide mask layer. Therefore, in the above process of preparing the P-type back contact solar cell, there is a problem that the phosphorus-doped silicon oxide mask layer has a narrow time window of protection to the polycrystalline silicon layer during texturing. That is, there is a short time interval between the start of texturing to the beginning of damage to the polycrystalline silicon layer.

In order to ensure that the polycrystalline silicon layer on the back surface of the P-type silicon wafer prepared by the above process will not be damaged, the texturing time has to be controlled within this narrow time window. However, if the texturing time is too short, the oxide layer and the polycrystalline silicon layer in the patterned region on the back surface of the P-type silicon wafer may not be etched cleanly, and P/N regions of the cell may not be effectively isolated, thereby affecting the conversion efficiency and the yield of the cell.

### SUMMARY

In view this, there is a need to provide a preparation method for a solar cell and a solar cell, which can improve the alkali resistance of the mask layer and expand the texturing time window.

The present application provides the following technical solutions.

According to an aspect of the present application, a preparation method for a solar cell is provided, including the following steps:
providing a silicon wafer having a first surface and a second surface opposite to the first surface;
forming an ultrathin silicon oxide layer on the first surface of the silicon wafer, and sequentially forming a phosphorus-doped amorphous silicon layer and a silicon oxide mask layer on the ultrathin silicon oxide layer; and
annealing the silicon wafer to densify the silicon oxide mask layer and convert the phosphorus-doped amorphous silicon layer into a phosphorus-doped polycrystalline silicon layer.

In some embodiments, the phosphorus-doped amorphous silicon layer and the silicon oxide mask layer are sequentially formed on the ultrathin silicon oxide layer by plasma-enhanced chemical vapor deposition.

In some embodiments, during forming the phosphorus-doped amorphous silicon layer and the silicon oxide mask layer by the plasma-enhanced chemical vapor deposition, a deposition temperature is from 350°C to 550°C.

In some embodiments, an annealing temperature in the annealing is from 800°C to 950°C, and an annealing time in the annealing is from 30 min to 120 min.

In some embodiments, the annealing temperature is from 850°C to 900°C.

In some embodiments, a thickness of the phosphorus-doped amorphous silicon layer is from 30 nm to 300 nm.

In some embodiments, a thickness of the phosphorus-doped amorphous silicon layer is from 100 nm to 150 nm.

In some embodiments, a thickness of the silicon oxide mask layer is from 10 nm to 100 nm.

In some embodiments, a thickness of the silicon oxide mask layer is from 20 nm to 50 nm.

In some embodiments, a thickness of the ultrathin silicon oxide layer is from 0.5 nm to 2.5 nm.

In some embodiments, the silicon wafer is a P-type silicon wafer.

In some embodiments, after the annealing the silicon wafer, the preparation method further includes: patterning the silicon oxide mask layer on the first surface to remove a part of the silicon oxide mask layer to form a patterned region.

In some embodiments, after the forming the patterned region, the preparation method further includes the following steps: soaking the first surface and the second surface of the silicon wafer with a texturing liquid to remove the ultrathin silicon oxide layer and the polycrystalline silicon layer in the patterned region and cause the second surface to form a textured surface.

In some embodiments, the texturing liquid is an alkali solution containing a texturing additive. The soaking is performed at a temperature of 35°C to 85°C for a time of 200 s to 550 s.

In some embodiments, after the soaking the first surface and the second surface, the preparation method further includes the following steps: depositing a passivation layer on the first surface or the second surface of the silicon wafer; and depositing an antireflection layer on the passivation layer on the first surface or the second surface.

In some embodiments, the passivation layer is an aluminum oxide layer, and a thickness of the passivation layer is from 2 nm to 25 nm.

In some embodiments, the antireflection layer is a layer of any one of or a combination of silicon nitride, silicon oxynitride, and silicon oxide, and a thickness of the antireflection layer is from 50 nm to 150 nm.

In some embodiments, after the depositing the antireflection layer, the preparation method further includes the following steps: providing patterned apertures in the patterned region on the first surface by laser, with the passivation layer and the antireflection layer in the apertures removed, to form an electrode contact region; and injecting an electrode paste into the electrode contact region and the polycrystalline silicon layer to form a first electrode and a second electrode, respectively.

In some embodiments, the first electrode is an aluminum grid-line electrode, and a width of the first electrode is from 50 µm to 200 µm.

In some embodiments, the second electrode is a silver grid-line electrode, and a width of the second electrode is from 10 µm to 50 µm.

According to another aspect of the present application, a solar cell is provided, which is prepared by the preparation method for the solar cell as described above in the present application.

Compared with the prior art, the present application has the following beneficial effects.

The conventional manufacturing process, where an amorphous silicon layer is firstly formed by LPCVD and subsequently undergoes phosphorus diffusion to produce doped amorphous silicon layer and silicon oxide mask layer, faces an issue with a narrow texturing time window. To address this problem, in the present application, the phosphorus-doped amorphous silicon layer and the silicon oxide mask layer are sequentially formed on the ultrathin silicon oxide layer and then annealed to densify the silicon oxide mask layer. In the present application, the silicon oxide mask layer is formed separately on the amorphous silicon layer, so that the thickness of the silicon oxide mask layer can be conveniently controlled according to an alkali resistance requirement. In addition, the silicon oxide mask layer is densified by annealing, further enhancing the corrosion resistance of the silicon oxide mask layer in an alkaline solution (e.g., a texturing liquid). In the method of the present application, the polycrystalline silicon layer in the N-type region can be well protected from corrosion, and the texturing time window in the subsequent texturing process is expanded.

### BRIEF DESCRIPTION OF THE DRAWINGS

FIG. 1 is a schematic structural view of a solar cell prepared according to an embodiment of the present application;
FIG. 2 is a bottom view of FIG. 1;
FIG. 3 is a schematic structural view of a P-type silicon wafer;
FIG. 4 is a schematic structural view of the P-type silicon wafer which has been deposited with several layers and annealed;
FIG. 5 is a bottom view of a silicon oxide mask layer which has been patterned;
FIG. 6 is a schematic structural view of the P-type silicon wafer which has been textured and with the silicon oxide mask layer removed; and
FIG. 7 is a bottom view of a patterned region which is provided with apertures.

### Reference numerals:

10: P-type silicon wafer; 11: first surface; 12: second surface; 21: ultrathin silicon oxide layer; 22: amorphous silicon layer; 23: silicon oxide mask layer; 30: polycrystalline silicon layer; 40: patterned region; 50: passivation layer; 60: antireflection layer; 70: electrode contact region; 80: first electrode; 90: second electrode; 100: P-type back contact solar cell.

### DETAILED DESCRIPTION

In order to make the above objectives, features, and advantages of the present application more apparent and understandable, specific embodiments of the present application will be described in detail below. In the following description, many specific details are set forth in order to fully understand the present application. However, the present application can be implemented in many other manners different from those described herein, and those skilled in the art can make similar improvements without departing from the connotation of the present application. Therefore, the present application is not limited by the specific embodiments described below.

In addition, the terms such as "first" and "second" are used for descriptive purposes only, which cannot be construed as indicating or implying a relative importance, or implicitly specifying the number of the indicated technical features. Therefore, the feature defined with "first" and "second" may explicitly or implicitly include at least one this feature. In the description of the present application, the term "a plurality of" means at least two, such as two or three, unless otherwise defined explicitly and specifically.

In the present application, unless otherwise specified and defined explicitly, the terms "mount", "connect", "join", and "fix" should be understood in a broad sense, which may be, for example, a fixed connection, a detachable connection, or an integral connection; a mechanical connection or an electrical connection; or a direct connection, an indirect connection via an intermediate medium, an internal connection between two elements, or interaction between two elements. Those of ordinary skill in the art can understand specific meanings of these terms in the present application according to specific situations.

Unless defined otherwise, all technical and scientific terms used herein have the same meanings as would commonly understood by those skilled in the art to which the present application pertains. The terms used herein in the specification of the present application are for the purpose of describing specific embodiments only, and are not intended to limit the present application. The term "and/or" used herein includes any and all combinations of one or more related listed items.

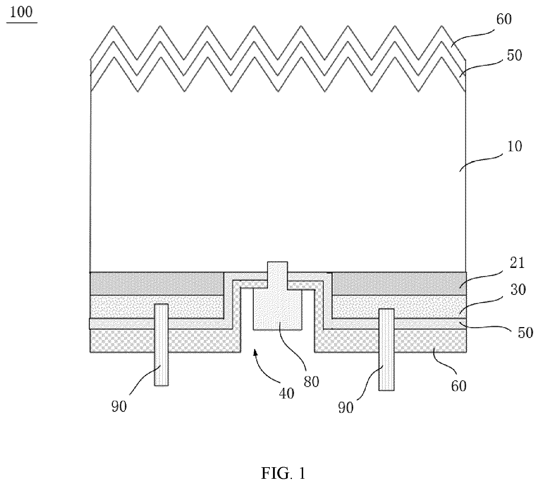

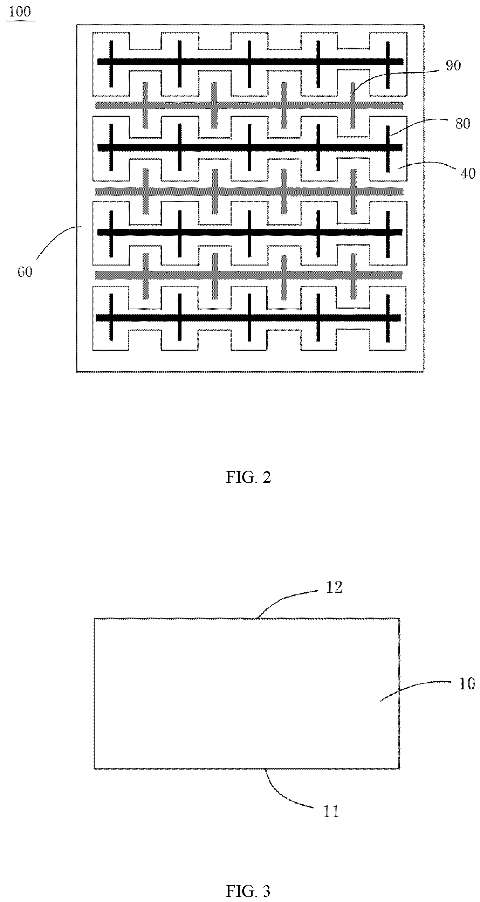

An embodiment of the present application provides a preparation method for a P-type back contact solar cell 100. A structure of the P-type back contact solar cell 100 is shown in FIG. 1 and FIG. 2. The preparation method includes step S100 to step S700 as follows.

In step S100, a P-type silicon wafer 10 is provided. The P-type silicon wafer 10 has a first surface 11 and a second surface 12 opposite to the first surface 11. A structure of the P-type silicon wafer 10 is shown in FIG. 3.

In the first surface 11 and the second surface 12 of the P-type silicon wafer 10, one surface is a light-receiving surface (i.e., a front surface) of the back contact solar cell 100, and the other face is a backlight surface (i.e., a back surface) of the back contact solar cell 100. In some embodiments, the first surface 11 of the P-type silicon wafer 10 is taken as the back surface, the second surface 12 is taken as the front surface, and both the PN junction region and the metal electrode are disposed on the first surface 11.

In some embodiments, the P-type silicon wafer 10 is also subjected to damage removal, polishing, and cleaning to make the surface of the P-type silicon wafer 10 clean and smooth to facilitate the subsequent layer-deposition process. A specific process is as follows: the surface of the P-type silicon wafer 10 is subjected to the damage removal with a solution containing KOH at about 60°C; then, the P-type silicon wafer 10 is polished with a solution containing KOH at about 75°C such that a surface reflectivity of the polished P-type silicon wafer 10 reaches 30%; and then, the polished P-type silicon wafer 10 is cleaned with a mixed solution containing hydrofluoric acid and hydrochloric acid and then with deionized water, and finally dried.

In step S200, an ultrathin silicon oxide layer 21 with a thickness of 0.5 nm to 2.5 nm is formed on the first surface 11 of the P-type silicon wafer 10, and a phosphorus-doped amorphous silicon layer 22 and a silicon oxide mask layer 23 are sequentially formed on the ultrathin silicon oxide layer 21 by PECVD.

In a specific embodiment, the ultrathin silicon oxide layer 21 is firstly deposited on the first surface 11 by PECVD, then the amorphous silicon layer 22 is deposited on the ultrathin silicon oxide layer 21 by PECVD, and then the silicon oxide mask layer 23 is deposited on the amorphous silicon layer 22 by PECVD.

In some other embodiments, the ultrathin silicon oxide layer 21 may alternatively be grown on the first surface 11 by thermal oxidation or looping oxidation, and then the amorphous silicon layer 22 and the silicon oxide mask layer 23 are sequentially deposited on the ultrathin silicon oxide layer 21 by PECVD.

When the amorphous silicon layer 22 is formed by PECVD, phosphorus doping is performed on the amorphous silicon layer 22 with SiH₄ as a silicon source and PH₃ gas as a phosphorus source. When the above layer is grown by PECVD, a deposition temperature is generally from 350°C to 550°C.

The ultrathin silicon oxide layer 21 is a silicon oxide layer immediately adjacent to the first surface 11. A thickness of the ultrathin silicon oxide layer 21 is from 0.5 nm to 0.25 nm. A thickness of the amorphous silicon layer 22 is from 30 nm to 300 nm, preferably 100 nm to 150 nm. A thickness of the silicon oxide mask layer 23 is from 10 nm to 100 nm, preferably 20 nm to 50 nm.

The ultrathin silicon oxide layer 21 and the phosphorus-doped amorphous silicon layer 22 form the PN junction together with the P-type silicon wafer 10, while the silicon oxide mask layer 23 mainly functions to protect the PN junction region (the ultrathin silicon oxide layer 21, the doped amorphous silicon layer 22, and the like) on the first surface 11 from corrosion by an alkali-containing texturing liquid in a subsequent texturing process.

Conventionally, a P-type back contact solar cell 100 is prepared by a process involves forming an amorphous silicon layer 22 by LPCVD and then performing phosphorus diffusion on the amorphous silicon layer 22 to form phosphorus-doped polycrystalline silicon layer 30 and silicon oxide mask layer 23 on the P-type silicon wafer 10. The silicon oxide mask layer 23 prepared by this manufacturing process is a phosphorosilicate glass (PSG) formed by the amorphous silicon layer 22 through the phosphorus diffusion. Such a silicon oxide mask layer 23 can protect the polycrystalline silicon layer 30 on a back surface of the P-type silicon wafer 10 to some extent during texturing, preventing the polycrystalline silicon layer 30 from being damaged by the alkali-containing texturing liquid to some extent.

However, since the silicon oxide mask layer 23 prepared by the above process is formed by phosphorus diffusion on the amorphous silicon layer 22, the growth of the silicon oxide mask layer 23 is a self-limiting reaction, and the prepared silicon oxide mask layer 23 generally has a very small thickness (less than 20 nm), resulting in a short resistance time to the alkali corrosion. Moreover, the high phosphorus doping concentration in the silicon oxide mask layer 23 may also reduce the alkali resistance of the silicon oxide mask layer 23. Generally, the higher the phosphorus doping concentration in the silicon oxide mask layer 23, the lower the alkali resistance of the silicon oxide mask layer 23. In the above process of preparing the P-type back contact solar cell 100, there is still a problem that the phosphorus-doped silicon oxide mask layer 23 has a narrow time window of protection to the polycrystalline silicon layer 30 during texturing. That is, there is a short time interval between the start of texturing to the beginning of damage to the polycrystalline silicon layer 30.

In the present application, the silicon oxide mask layer 23 is formed separately on the amorphous silicon layer 22 by PECVD, so that the thickness of the silicon oxide mask layer 23 can be conveniently controlled according to an actual requirement on the alkali resistance of the silicon oxide mask layer 23. The thickness of the silicon oxide mask layer 23 may be up to 100 nm, while the thickness of the silicon oxide mask layer 23 formed by LPCVD in combination with phosphorus diffusion is generally less than 20 nm. Under the same layer-deposition process conditions, a growth rate of a deposited layer is in a linear relationship with time, enabling the growth thickness of the silicon oxide mask layer 23 to be conveniently controlled by controlling a deposition time in PECVD. Under the same alkali corrosion conditions, the thickness of the silicon oxide mask layer 23 is proportional to the resistance time to the alkali corrosion. That is, if the thickness of the silicon oxide mask layer 23 is increased, the resistance time of the silicon oxide mask layer 23 to the alkali corrosion will also be prolonged. By using the method in the present application, the silicon oxide mask layer 23 with a larger thickness can be obtained, effectively expanding the texturing time window in the subsequent texturing process.

In the present application, the amorphous silicon layer 22 and the silicon oxide mask layer 23 are separately formed by PECVD, instead of separately forming the amorphous silicon layer 22 by LPCVD and additionally forming the silicon oxide mask layer 23. The primary reason for this choice is as follows. In LPCVD, amorphous silicon/polycrystalline silicon is generally deposited at a temperature of 550°C to 650°C. While it is possible to grow silicon oxide at the outer side by introducing oxygen directly into the LPCVD device, the growth thickness of the silicon oxide in relation to temperature/time follows a parabolic curve. This means that achieving a silicon oxide of greater than 10 nm at 600°C can take several hours. To prevent alkaline corrosion and increase phosphorus diffusion concentration, it becomes necessary to elevate the diffusion and oxidation temperature to over 800°C for rapid silicon oxide thickening. Consequently, the device must be heated from the LPCVD deposition temperature of the amorphous silicon/polycrystalline silicon (550°C to 650°C) to over 800°C and then cooled down for the subsequent batch of silicon wafers in the manufacturing process. This continuous cycling of the device between temperatures, with a difference exceeding 200°C, demands an additional process time of over two hours. Splitting the LPCVD deposition and doping-element diffusion and oxidation into two separate devices is a more cost-effective approach. Thus, in the present application, the amorphous silicon layer 22 and the silicon oxide mask layer 23 are separately formed using PECVD.

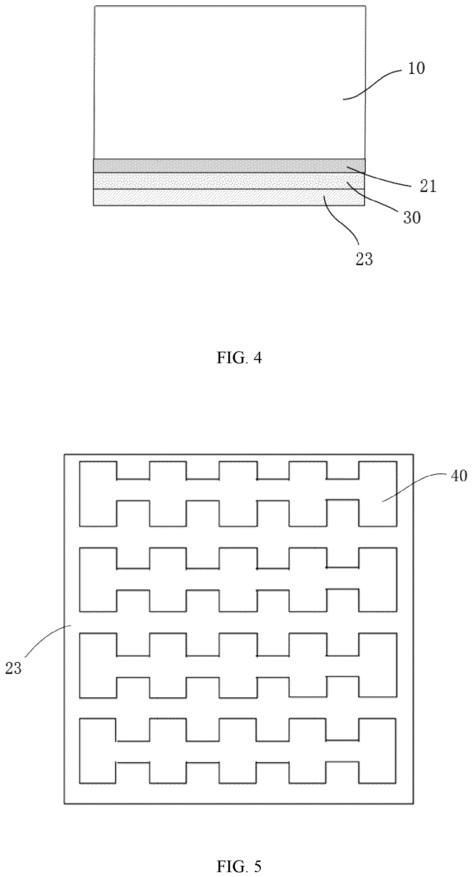

In step S300, the silicon wafer 10 is annealed to densify the silicon oxide mask layer 23 and crystallize the phosphorus-doped amorphous silicon layer 22 into a phosphorus-doped polycrystalline silicon layer 30. A structure of the annealed P-type silicon wafer 10 and layers thereof is shown in FIG. 4.

In the present application, the silicon oxide mask layer 23 prepared by PECVD is annealed to densify the silicon oxide mask layer 23. Whether grown by PEVCD or LPCVD, the obtained silicon oxide mask layer 23 is generally relatively loose, with some voids therein, which affects the alkali corrosion resistance thereof. In the present application, the silicon oxide mask layer 23 is annealed. During high-temperature annealing, silicon oxide grown by PECVD will become denser, eliminating some voids inside the layer, which can enhance the corrosion resistance of the silicon oxide mask layer 23 in an alkaline solution, thereby better protecting the N-type region (the crystalline silicon layer and the like) from corrosion, prolonging the texturing time window in the subsequent texturing process, and reducing a risk of leakage of the cell.

At the same time, during the annealing, the amorphous silicon (a-Si) deposited by PEVCD will be converted into polycrystalline silicon (poly) and the grains will grow larger, allowing the phosphorus-doped amorphous silicon layer 22 to be converted into the polycrystalline silicon layer 30.

In some embodiments, an annealing temperature in the annealing is from 800°C to 950°C, and an annealing time is from 30 min to 120 min. Under this annealing process conditions, the silicon oxide mask layer 23 can be fully densified, effectively expanding the texturing time window, and the phosphorus-doped amorphous silicon layer 22 can be fully converted into the phosphorus-doped polycrystalline silicon layer 30.

It should be understood that the annealing temperature may be a specific value such as 800°C, 820°C, 850°C, 880°C, 900°C, 920°C, or 950°C. Further preferably, the annealing temperature is from 850°C to 900°C. The annealing time may be a specific value such as 30 min, 40 min, 60 min, 80 min, 100 min, or 120 min.

In step S400, after the P-type silicon wafer 10 is annealed, the silicon oxide mask layer 23 on the first surface 11 is patterned to remove a part of the silicon oxide mask layer 23, thereby forming a patterned region 40. A structure obtained after patterning is shown in FIG. 5.

After the silicon oxide mask layer 23 on the first surface 11 is annealed, in the present application, the silicon oxide mask layer 23 on the first surface 11 is patterned to remove a part of the silicon oxide mask layer 23 on the first surface 11, thereby forming the patterned region 40. The patterned region 40 is used to prepare an electrode directly connected to the P-type silicon wafer 10. A width of the patterned region 40 is from 300 µm to 500 µm. The silicon oxide mask layer 23 can be patterned using an existing process in the art, as long as a part of the silicon oxide mask layer 23 can be removed according to a certain pattern.

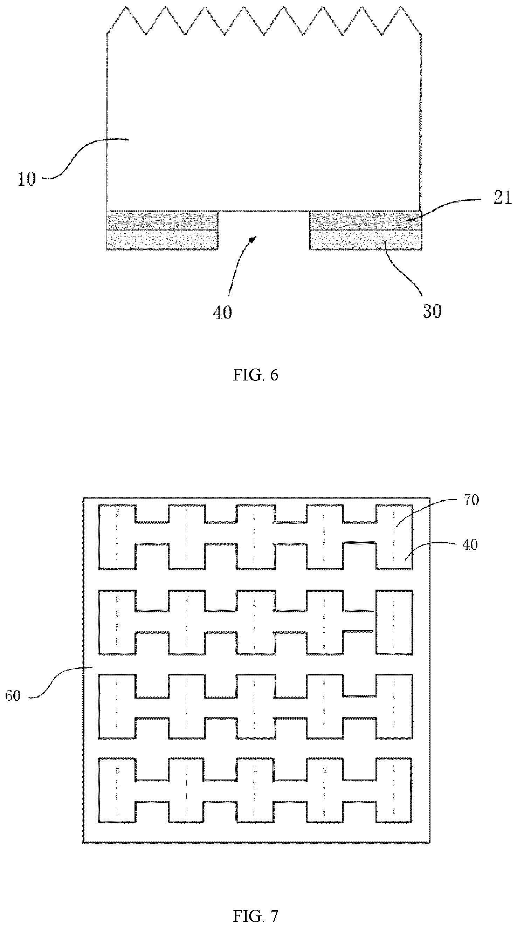

In step S500, after the patterned region 40 is formed, the first surface 11 and the second surface 12 of the P-type silicon wafer 10 are soaked with a texturing liquid to remove the ultrathin silicon oxide layer 21 and the polycrystalline silicon layer 30 in the patterned region 40 and cause the second surface 11 to form a textured surface. The entire texturing process is performed in a plurality of tanks. After the texturing is completed, the P-type silicon wafer 10 is subjected to cleaning with deionized water, alkali cleaning (with a mixture solution of alkali and hydrogen peroxide), cleaning with deionized water, acid cleaning (with hydrofluoric acid which can remove the silicon oxide mask, or a mixture solution of hydrofluoric acid and hydrochloric acid), cleaning with deionized water, and soaking with hydrofluoric acid, and the resulted structure with the silicon oxide mask layer 23 removed is shown in FIG. 6.

Through the above method, the second surface 12 (i.e., the front surface) of the P-type silicon wafer 10 can be textured to form a textured surface, and at the same time, the patterned region 40 on the first surface 11 can be etched to effectively remove the ultrathin silicon oxide layer 21 and the polycrystalline silicon layer 30 in the patterned region 40, thereby exposing the first surface 11 corresponding to the patterned region 40. Other regions on the back surface of the cell will not be corroded and damaged by the texturing liquid due to the protection of the silicon oxide mask layer 23. After the texturing is completed, the silicon oxide mask layer 23 can be removed by acid cleaning with a solution containing hydrofluoric acid.

In some embodiments, the texturing liquid is an alkali solution containing a texturing additive, and the soaking in texturing is performed at a temperature of 35°C to 85°C for a time of 200 s to 550 s. Under those process conditions, the second surface 12 of the P-type silicon wafer 10 can be fully textured to form a textured surface, while the ultrathin silicon oxide layer 21 and the polycrystalline silicon layer 30 in the patterned region 40 can be effectively removed to expose the corresponding first surface 11 without texturing the exposed first surface 11.

In step S600, each of the first surface 11 and the second surface 12 of the P-type silicon wafer 10 is formed with a passivation layer 50 thereon. Then, the passivation layer 50 on each of the first surface 11 and the second surface 12 is formed with an antireflection layer 60 thereon. By forming the passivation layer 50 and the antireflection layer 60, a passivation effect and an effect of reducing the reflectivity of the cell can be achieved respectively.

In some embodiments, the passivation layer 50 is an aluminum oxide layer grown by atomic layer deposition (ALD). A thickness of the passivation layer 50 is from 2 nm to 25 nm. The antireflection layer 60 is a layer of any one of or a combination of silicon nitride, silicon oxynitride, and silicon oxide. A thickness of the antireflection layer 60 is from 50 nm to 150 nm.

In step S700, patterned apertures are provided in the patterned region 40 on the first surface 11 of the P-type silicon wafer 10 by laser, with the passivation layer 50 and the antireflection layer 60 in the apertures removed, to form an electrode contact region 70. Then an electrode paste is injected into the electrode contact region 70 and the polycrystalline silicon layer 30 (a burn-through paste, which can burn through the passivation layer 50 and the antireflection layer 60, is injected into the polycrystalline silicon layer 30) to form a first electrode 80 and a second electrode 90 respectively. A structure with the apertures provided in the patterned region 40 is shown in FIG. 7.

The first electrode 80 is directly connected to the silicon wafer 10, and the second electrode 90 is directly connected to the polycrystalline silicon layer 30 in a region other than the patterned region 40 on the first surface 11. In some embodiments, the first electrode 80 is an aluminum grid-line electrode. A width of the first electrode 80 is from 50 µm to 200 µm. The second electrode 90 is a silver grid-line electrode. A width of the second electrode 90 is from 10 µm to 50 µm.

Specifically, when the patterned apertures are provided in the patterned region 40 by laser, the aperture regions are distributed in a dotted line or in dots. A width of the aperture is from 30 µm to 50 µm.That is, a width of the electrode contact region 70 is from 30 µm to 50 µm.Electrode paste layers containing conductive components may be formed in the electrode contact region 70 and the polycrystalline silicon layer 30 by screen printing to serve as the first electrode 80 and the second electrode 90, respectively.

Another embodiment of the present application provides another preparation method for a P-type back contact solar cell 100. The preparation method includes steps S100 to step S1000 as follows.

In step S100, a P-type silicon wafer 10 is provided. The P-type silicon wafer 10 has a first surface 11 and a second surface 12 opposite to the first surface 11.

In the first surface 11 and the second surface 12 of the P-type silicon wafer 10, one surface is a light-receiving surface (i.e., a front surface) of the back contact solar cell 100, and the other surface is a backlight surface (i.e., a back surface) of the back contact solar cell 100. In some embodiments, the first surface 11 of the P-type silicon wafer 10 is taken as the back surface, the second surface 12 is taken as the front surface, and both the PN junction region and the metal electrode are disposed on the first surface 11.

In some embodiments, the P-type silicon wafer 10 is also subjected to damage removal, polishing, and cleaning to make the surface of the P-type silicon wafer 10 clean and smooth to facilitate the subsequent layer-deposition process. A specific process is as follows: the surface of the P-type silicon wafer 10 is subjected to the damage removal with a solution containing KOH at about 60°C; then, the P-type silicon wafer 10 is polished with a solution containing KOH at about 75°C such that a surface reflectivity of the polished P-type silicon wafer 10 reaches 30%; and then, the polished P-type silicon wafer 10 is cleaned with a mixed solution containing hydrofluoric acid and hydrochloric acid and then with deionized water, and finally dried.

In step S200, an ultrathin silicon oxide layer 21 with a thickness of 0.5 nm to 2.5 nm is formed on the first surface 11 of the P-type silicon wafer 10, and a phosphorus-doped amorphous silicon layer 22 and a silicon oxide mask layer 23 are sequentially formed on the ultrathin silicon oxide layer 21 by PECVD.

In a specific embodiment, the ultrathin silicon oxide layer 21 is firstly deposited on the first surface 11 by PECVD, then the amorphous silicon layer 22 is deposited on the ultrathin silicon oxide layer 21 by PECVD, and then the silicon oxide mask layer 23 is deposited on the amorphous silicon layer 22 by PECVD.

In some other embodiments, the ultrathin silicon oxide layer 21 may alternatively be grown on the first surface 11 by thermal oxidation or looping oxidation, and then the amorphous silicon layer 22 and the silicon oxide mask layer 23 are sequentially deposited on the ultrathin silicon oxide layer 21 by PECVD.

When the amorphous silicon layer 22 is formed by PECVD, phosphorus doping is performed on the amorphous silicon layer 22 with SiH₄ as a silicon source and PH₃ gas as a phosphorus source. When the above layer is grown by PECVD, a deposition temperature is generally from 350°C to 550°C.

The ultrathin silicon oxide layer 21 is a silicon oxide layer immediately adjacent to the first surface 11. A thickness of the ultrathin silicon oxide layer 21 is from 0.5 nm to 0.25 nm. A thickness of the amorphous silicon layer 22 is from 30 nm to 300 nm, preferably 100 nm to 150 nm. A thickness of the silicon oxide mask layer 23 is from 10 nm to 100 nm, preferably 20 nm to 50 nm.

In step S300, the silicon wafer 10 is annealed to densify the silicon oxide mask layer 23 and crystallize the phosphorus-doped amorphous silicon layer 22 into a phosphorus-doped polycrystalline silicon layer 30.

During the annealing, the amorphous silicon (a-Si) deposited by PEVCD will be converted into polycrystalline silicon (poly) and the grains will grow larger, allowing the phosphorus-doped amorphous silicon layer 22 to be converted into the polycrystalline silicon layer 30, and allowing the silicon oxide mask layer 23 to be densified.

In some embodiments, an annealing temperature in the annealing is from 800°C to 950°C, and an annealing time is from 30 min to 120 min.

In step S400, a chain HF solution (with a volume fraction of hydrofluoric acid from 5% to 35%, at normal temperature) is used to remove only a silicon oxide mask wrap-around on the second surface 12 ("chain" means being placed horizontally and traveling horizontally, that is, an upper surface is covered with a water film, a lower surface reacts with the solution, and the solution is no higher than the upper surface).

In step S500, a tank-texturing is performed. A complete process of texturing includes alkali washing (with hydrogen peroxide in combination with a strong monobasic base such as NaOH/KOH, at a temperature of 50°C to 65°C, with an alkali volume fraction of 0.3% to 1.5%, for a time of 60 s to 300 s), cleaning with deionized water, texturing, cleaning with deionized water, alkali cleaning, cleaning with deionized water, acid cleaning (with a solution of hydrochloric acid with no hydrofluoric acid, because HF reacts with silicon oxide and the previous silicon oxide mask layer 23 may be removed), cleaning with deionized water, and drying.

In step S600, the second surface 12 is subject to high-temperature oxidation. In this case, the second surface 12 has been textured without silicon oxide protection. The high-temperature oxidation is performed at a temperature of 700°C to 900°C for a time of 20 min to 50 min.

In step S700, the silicon oxide mask layer 23 on the first surface 11 is patterned to remove a part of the silicon oxide mask layer 23, thereby forming a patterned region 40.

In step S800, a tank-etching is performed. A process thereof includes etching-water washing-alkali washing-water washing-acid washing (HF is contained, and the excess silicon oxide mask layer 23 is removed from the front and back surfaces)-water washing-drying.

In step S900, each of the first surface 11 and the second surface 12 of the P-type silicon wafer 10 is formed with a passivation layer 50 thereon. Then, the passivation layer 50 on each of the first surface 11 and the second surface 12 is formed with an antireflection layer 60 thereon.

In step S1000, patterned apertures are provided in the patterned region 40 on the first surface 11 of the silicon wafer 10 by laser, with the passivation layer 50 and the antireflection layer 60 in the apertures removed, to form an electrode contact region 70. Then an electrode paste is injected into the electrode contact region 70 and the polycrystalline silicon layer 30 (a burn-through paste, which can burn through the passivation layer 50 and the antireflection layer 60, is injected into the polycrystalline silicon layer 30) to form a first electrode 80 and a second electrode 90 respectively.

The technical features of the above embodiments can be combined arbitrarily. In order to make the description concise, not all possible combinations of the technical features are described in the embodiments. However, as long as there is no contradiction in the combination of these technical features, the combinations should be considered as in the scope of the specification.

The above embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A preparation method for a solar cell, comprising steps of:
providing a silicon wafer having a first surface and a second surface opposite to the first surface;
forming an ultrathin silicon oxide layer on the first surface of the silicon wafer, and sequentially forming a phosphorus-doped amorphous silicon layer and a silicon oxide mask layer on the ultrathin silicon oxide layer; and
annealing the silicon wafer to densify the silicon oxide mask layer and convert the phosphorus-doped amorphous silicon layer into a phosphorus-doped polycrystalline silicon layer.

2. The preparation method for the solar cell of claim 1, wherein the phosphorus-doped amorphous silicon layer and the silicon oxide mask layer are sequentially formed on the ultrathin silicon oxide layer by plasma-enhanced chemical vapor deposition.

3. The preparation method for the solar cell of claim 2, wherein during forming the phosphorus-doped amorphous silicon layer and the silicon oxide mask layer by the plasma-enhanced chemical vapor deposition, a deposition temperature is from 350°C to 550°C.

4. The preparation method for the solar cell of any one of claims 1 to 3, wherein in the annealing, an annealing temperature is from 800°C to 950°C, and an annealing time is from 30 min to 120 min.

5. The preparation method for the solar cell of any one of claims 1 to 4, wherein an annealing temperature in the annealing is from 850°C to 900°C.

6. The preparation method for the solar cell of any one of claims 1 to 5, wherein a thickness of the phosphorus-doped amorphous silicon layer is from 30 nm to 300 nm.

7. The preparation method for the solar cell of any one of claims 1 to 6, wherein a thickness of the phosphorus-doped amorphous silicon layer is from 100 nm to 150 nm.

8. The preparation method for the solar cell of any one of claims 1 to 7, wherein a thickness of the silicon oxide mask layer is from 10 nm to 100 nm.

9. The preparation method for the solar cell of any one of claims 1 to 8, wherein a thickness of the silicon oxide mask layer is from 20 nm to 50 nm.

10. The preparation method for the solar cell of any one of claims 1 to 9, wherein a thickness of the ultrathin silicon oxide layer is from 0.5 nm to 2.5 nm.

11. The preparation method for the solar cell of claim 1, wherein the silicon wafer is a P-type silicon wafer.

12. The preparation method for the solar cell of any one of claims 1 to 11, wherein after the annealing the silicon wafer, the preparation method further comprises:
patterning the silicon oxide mask layer on the first surface to remove a part of the silicon oxide mask layer to form a patterned region.

13. The preparation method for the solar cell of claim 12, wherein after the forming the patterned region, the preparation method further comprises a step of:
soaking the first surface and the second surface of the silicon wafer in a texturing liquid to remove the ultrathin silicon oxide layer and the polycrystalline silicon layer in the patterned region and cause the second surface to form a textured surface.

14. The preparation method for the solar cell of claim 13, wherein the soaking is performed at a temperature of 35°C to 85°C for a time of 200 s to 550 s.

15. The preparation method for the solar cell of claim 13 or 14, wherein after the soaking the first surface and the second surface, the preparation method further comprises a step of:
depositing a passivation layer on the first surface or the second surface of the silicon wafer; and
depositing an antireflection layer on the passivation layer on the first surface or the second surface.

16. The preparation method for the solar cell of claim 15, wherein the passivation layer is an aluminum oxide layer, and a thickness of the passivation layer is from 2 nm to 25 nm.

17. The preparation method for the solar cell of claim 15 or 16, wherein the antireflection layer is a layer of any one of or a combination of silicon nitride, silicon oxynitride, and silicon oxide, and a thickness of the antireflection layer is from 50 nm to 150 nm.

18. The preparation method for the solar cell of any one of claims 15 to 17, wherein after the depositing the antireflection layer, the preparation method further comprises steps of:
providing patterned apertures in the patterned region on the first surface by laser, with the passivation layer and the antireflection layer in the apertures removed, to form an electrode contact region; and
injecting an electrode paste into the electrode contact region and the polycrystalline silicon layer to form a first electrode and a second electrode, respectively.

19. The preparation method for the solar cell of claim 18, wherein the first electrode is an aluminum grid-line electrode, and a width of the first electrode is from 50 µm to 200 µm.

20. The preparation method for the solar cell of claim 18 or 19, wherein the second electrode is a silver grid-line electrode, and a width of the second electrode is from 10 µm to 50 µm.

21. A solar cell, wherein the solar cell is prepared by the preparation method of any one of claims 1 to 20.
